# EUROPEAN PATENT SPECIFICATION

(11) **EP 0 279 406 B1**
(45) Date of publication and mention of the grant of the patent: **10.01.1996**
(21) Application number: 88102214.9
(22) Date of filing: 15.02.1988
(51) Int. Cl.: C23C 8/10

(54) **Device for forming silicon oxide film**
Vorrichtung zur Herstellung einer Siliziumoxydschicht
Appareil pour former des films de silice

(30) Priority: 16.02.1987 JP 34058/87
(43) Date of publication of application: 24.08.1988
(73) Proprietor: CANON KABUSHIKI KAISHA, Tokyo (JP)
(72) Inventor: Matsumoto, Shigeyuki, Atsugi-shi Kanagawa-ken (JP)
(74) Representative: Bühling, Gerhard, Dipl.-Chem.

(56) References cited:
- PATENT ABSTRACTS OF JAPAN, vol. 8, no. 8 (E-221)[1445], 13th January 1984; & JP-A-58 173 837 (SANYO DENKI K.K.) 12-10-1983
- PATENT ABSTRACTS OF JAPAN, vol. 6, no. 81 (E-107)[959], 19th May 1982; & JP-A-57 18 328 (KINMON SEISAKUSHO K.K.) 30-01-1982
- PATENT ABSTRACTS OF JAPAN, vol. 7, no. 123 (E-178)[1268], 27th May 1983; & JP-A-58 42 239 (HANDOUTAI ENERUGII KENKYUSHO K.K.) 11- 03-1983
- PATENT ABSTRACTS OF JAPAN, vol. 4, no. 4 (E-164), 12th Jaunary 1980; & JP-A-54 144 867 (HITACHI SEISAKUSHO K.K.) 12-11-1979

## Description

### Device for Forming Silicon Oxide Film

### BACKGROUND OF THE INVENTION

### Field of the Invention

This invention relates to a silicon oxide film forming technique which is intended to improve yield, quality, uniformity during formation of a silicon oxide film on a silicon surface.

### Related Background Art

Silicon oxide film forming methods may include the thermal oxidation method, the vacuum deposition method, the CVD method, etc., and generally the thermal oxidation method has been utilized. The thermal oxidation method comprises heating a silicon substrate in an oxidative atmosphere to a predetermined high temperature, thereby forming a film of silicon oxide on the surface of the substrate.

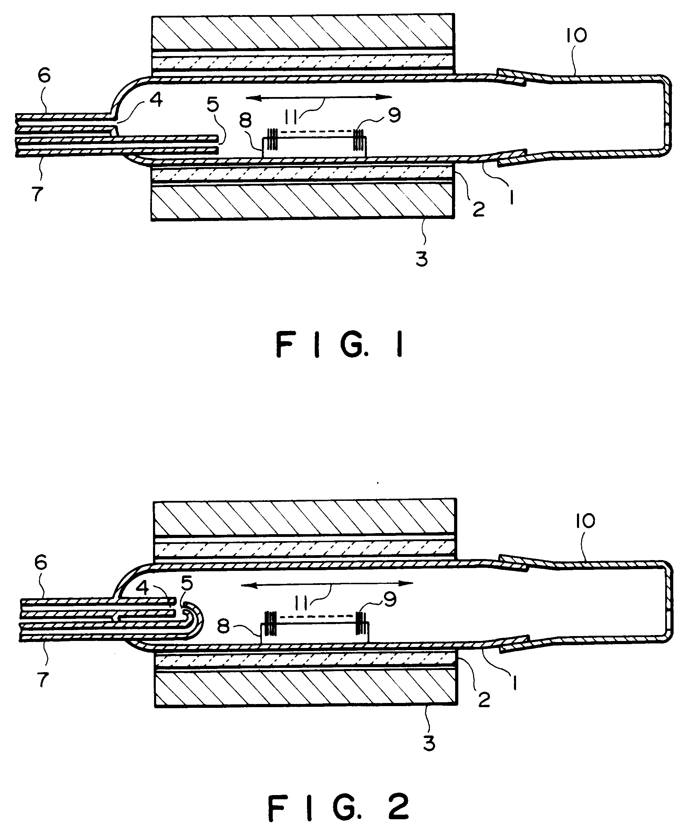

The device for forming a silicon oxide film by the thermal oxidation method of the prior art is constituted of a heating portion 3, a uniform heating tube portion 2 and a quartz tube portion 1, as shown in Fig. 1, and has a structure capable of introducing various gases into the quartz tube portion 1. In the device of the prior art shown in Fig. 1, a plural number of gas introducing pipes are connected to the quartz tube portion. That is, an oxygen gas introducing hole is positioned at the end of the quartz tube and an hydrogen gas introducing hole is positioned in a high temperature region in the quartz tube away from the oxygen gas introducing hole so that the hydrogen gas supplied may be efficiently subjected to combustion in a short time and that stable combustion with little change in spread of the flame may be obtained.

In the prior art, oxygen gas is flowed through the introducing pipe 6 to fill internally the quartz tube portion 1 with oxygen atmosphere and, 2 to 5 minutes later, hydrogen gas is flowed through the introducing pipe 7 for combustion. At that time, the surface of the substrate made of silicon 9 located within the quartz tube is oxidized with the flow of the water vapor generated. In this case, it is generally practiced to control the oxide film thickness by temperature and time.

However, in the prior art device as described above, mixing of hydrogen gas and oxygen gas cannot be sufficient, and the water vapor stream also tended to be nonuniform. Therefore, the device had the problems such as nonuniformity of silicon oxide film thickness within the plane of a wafer, and difference in silicon oxide film thickness between the front portion and the rear portion within the quartz boat, and great variance relative to a desired value, etc. The present inventor has discovered nonuniformity of the silicon oxide film thickness results from the fact that the hydrogen gas introducing hole is distant from the oxygen gas introducing hole.

### SUMMARY OF THE INVENTION

The present invention has been accomplished in view of the problems of the prior art as described above, and its object is to provide a silicon oxide film forming device, capable of supplying stably a silicon oxide film the thickness of which is uniform within the wafer plane, and does not depend on the position of the wafer located within the quartz boat and is also small in variance relative to a desired value.

According to the present invention, there is provided a device for forming a silicon oxide film, said device comprising a quartz tube housing, a substrate comprising silicon, means for heating internally said quartz tube and gas introducing pipes having gas introducing holes facing each other for delivering and flowing hydrogen gas and oxygen gas into said quartz tube to effect hydrogen combustion, wherein the gas introducing holes are positioned in a distance of 450 mm or less.

### BRIEF DESCRIPTION OF THE DRAWINGS

Fig. 1 is a drawing for illustration of the prior art and Fig. 2 is a drawing showing an example of the present invention.

### DESCRIPTION OF THE PREFERRED EMBODIMENTS

The present invention is described below by referring to Fig. 2.

The silicon oxide film forming device according to the present invention, as shown in Fig. 2, is constituted of a heater portion 3 added with a means for heating the quartz tube 1 and controlling the heated temperature, a uniform heating tube portion 2 for expanding uniformly heating in the quartz tube 1 in the diameter direction and the axial direction, a quartz boat 8 for locating the silicon substrate 9 thereon and a quartz cap 10 for preventing entrainment of the outer air.

The above quartz tube 1 is provided with gas introducing pipes 6, 7, and has a structure which can permit predetermined gases to flow selectively through the gas introducing holes 4, 5 by opening of the valve not shown.

Here, the gas introducing holes 4, 5 are positioned in the neighborhood with a distance of 450 mm or less in order to effect hydrogen combustion efficiently and uniformly to generate uniform water vapor stream.

The quartz tube 1, because its degree of cleanness influences the film quality of the silicon oxide film, is constantly under flow of a gas of high purity through the gas introducing hole 4.

Further, the silicon substrate 9 on which the silicon oxide film is formed is located in plural sheets on the quartz boat 8, which are to be moved toward the uniform heating portion 11 of the quartz tube 1 through the soft landing mechanism, etc.

In the present invention, prior to forming a silicon oxide film, the quartz tube 1 is previously filled internally with nitrogen atmosphere delivered and flowed through the gas introducing pipe 6. Therefore, no fragile silicon oxide film with low packing density which will be formed in oxygen atmosphere will be formed.

The substrate made of silicon 9 and the quartz boat 8, after located at the predetermined positions, are left to stand for 30 seconds to 5 minutes until the temperature becomes uniform.

Then, by opening the valve not shown, oxygen gas is delivered through the gas introducing pipe 6, the gas introducing hole 4 and hydrogen gas through the gas introducing pipe 7 and the gas introducing hole 5, into the quartz tube 1, where combustion is effected.

According to the present invention, since the gas introducing holes 4, 5 are arranged in the neighborhood and also both are opposed to each other, hydrogen gas and oxygen gas are delivered and flowed in opposite directions. Accordingly, both gases can be mixed sufficiently to efficiently effect hydrogen combustion, thereby making water vapor uniform.

For this reason, a silicon oxide film with a uniform film thickness within wafer plane, within batch and between batches can be formed with good reproducibility.

The conditions and procedures used for practicing the present invention are shown below.

The substrate formed of silicon 9 is left to stand in the quartz tube 1 filled with nitrogen atmosphere, and after uniform heating thereof at a predetermined temperature, delivery of nitrogen is stopped for making hydrogen gas readily combustible, and oxygen at 2 to 8 ℓ/min. and hydrogen at 1 to 5 ℓ/min. are flowed at the same time.

During that operation, the inner temperature of the quartz tube 1 should be desirably 800 to 900 °C for a thin oxide film, and 900 to 1100 °C for a thick oxide film, for the purpose of lowering the Si-SiO₂ interface level. The film thickness is controlled by the time of hydrogen combustion effected by delivering and flowing hydrogen and oxygen. Also, for lowering stably the interface level, after termination of hydrogen combustion, nitrogen is flowed at 2 to 8 ℓ/min. to complete formation of a silicon oxide film.

The condition for practicing the present invention is not limited to the range set forth above.

The present invention will be described below by referring to an example.

### Example

A substrate made of silicon was set in a quartz tube filled with nitrogen atmosphere. The quartz tube was heated internally to 850 °C and allowed to stand for 3 minutes to effect uniform heating. Next, introduction of nitrogen was stopped, and oxygen at 2ℓ/min. through the gas introducing hole 4 and hydrogen at 3ℓ/min. through the gas introducing hole 5 were introduced into the quartz tube in the opposite flowing directions with a distance of 400 mm between the introducing holes 4, 5 to effect hydrogen combustion. Generation of water vapor by hydrogen combustion was continued for 10 minutes and then stopped, thereby completing formation of a silicon oxide film. Then, only nitrogen was flowed into the quartz tube at a flow rate of 5ℓ/min. for 20 minutes.

The silicon oxide film obtained in this example had a uniform thickness throughout the whole surface of wafer. Furthermore, the silicon oxide film formed also had a uniform thickness within batch and between batches.

The uniformity of the thickness of the silicon oxide film obtained in the example was compared with that of a silicon oxide film obtained by use of the prior art device as shown in Fig. 1 with respect to average film thickness and 3σ (σ is the standard deviation). The silicon oxide film by use of the prior art device was formed with the same treating temperature (850°C), supplied gas amounts (hydrogen:3ℓ/min. oxygen:2ℓ/min.) and treating time as those in the example.

The film thickness was measured at 33 points within the wafer surface including the center and other 32 points on two lines perpendicularly crossing at the center with a pitch of 5 mm within 40 mm from the center, and uniformity was evaluated by statistical process. The results are shown in Table 1.

**Table 1**

| Distribution of silicon oxide film thicknesses within surface (Desired film thickness: 20nm (200 Å)) | | | | |
|---|---|---|---|---|
| Gas inflow direction and distance between gas introducing holes | Same direction 500 mm (Prior art) | | Opposite direction 400 mm (Example) | |
| | Average film thickness 3σ | | Average film thickness 3σ | |
| First time | 19.5nm (195Å) | 1.3nm (13Å) | 20.2nm (202Å) | 0.8nm (8Å) |
| Second time | 20.1nm (201Å) | 0.9nm (9Å) | 19.6nm (196Å) | 1.0nm (10Å) |
| Third time | 19.9nm (199Å) | 1.1nm (11Å) | 19.8nm (198Å) | 0.6nm (6Å) |

As described above, the silicon oxide film forming device in accordance with the present invention can stably supply with good reproducibility a silicon oxide film which has a uniform thickness within the wafer surface as compared with the prior art device.

## Claims

1. A device for forming a silicon oxide film on a silicon substrate (9), said device comprising a quartz tube (1), in which said substrate is housed, means (2, 3) for heating internally said quartz tube and gas introducing pipes (6, 7) having gas introducing holes (4, 5) facing each other for delivering and flowing hydrogen gas and oxygen gas into said quartz tube to effect hydrogen combustion, characterized in that the gas introducing holes (4, 5) are positioned in a distance of 450 mm or less.

2. The device according to claim 1, characterized in that the gas introducing pipes (6, 7) are arranged substantially parallel to each other at the same end of the quartz tube (1) and the end portion of the gas introducing pipe (7) is bent such that the gas introducing holes (4, 5) face each other.

3. The device according to claims 1 or 2, characterized in that said gas introducing holes open in an area of the quartz tube (1) surrounded by the means (2, 3) for heating said quartz tube.

## Patentansprüche

1. Vorrichtung zur Herstellung einer Siliciumoxidschicht auf einem Siliciumsubstrat (9), wobei die Vorrichtung eine Quarzröhre (1), in der das Substrat untergebracht ist, eine Einrichtung zum inneren Erwärmen der Quarzröhre, und Gaseinleitungsrohre (6, 7) mit Gaseinleitungsöffnungen (4, 5), die einander gegenüberliegen, um Wasserstoffgas und Sauerstoffgas zuzuführen und in die Quarzröhre einströmen zu lassen, um eine Verbrennng des Wasserstoffs durchzuführen, umfaßt,
**dadurch gekennzeichnet, daß**
die Gaseinleitungsöffnungen (4, 5) in einem Abstand von 450 mm oder weniger angeordnet sind.

2. Verfahren nach Anspruch 1,
**dadurch gekennzeichnet, daß**
die Gaseinleitungsrohre (6, 7) am gleichen Ende der Quarzröhre (1) im wesentlichen parallel zueinander angeordnet sind und der Endabschnitt des Gaseinleitungsrohres (7) derart gebogen ist, daß die Gaseinleitungsöffnungen (4, 5) einander gegenüberliegen.

3. Verfahren nach Anspruch 1 oder Anspruch 2,
**dadurch gekennzeichnet, daß**
die Gaseinleitungsöffnungen sich in einem Bereich der Quarzröhre (1) öffnen, der von der Einrichtung (2, 3) zum Heizen der Quarzröhre umgeben ist.

## Revendications

1. Dispositif pour former un film d'oxyde de silicium sur un substrat (9) en silicium, ledit dispositif comportant un tube (1) de quartz, dans lequel ledit substrat est logé, des moyens (2, 3) destinés à chauffer intérieurement ledit tube de quartz et des conduits (6, 7) d'introduction de gaz présentant des trous (4, 5) d'introduction de gaz disposés face à face pour distribuer et introduire par écoulement de l'hydrogène gazeux et de l'oxygène gazeux dans ledit tube de quartz pour effectuer une combustion de l'hydrogène, caractérisé en ce que les trous (4, 5) d'introduction de gaz sont positionnés à une distance de 450 mm ou moins.

2. Dispositif selon la revendication 1, caractérisé en ce que les conduits (6, 7) d'introduction de gaz sont disposés de façon à être sensiblement parallèles entre eux à la même extrémité du tube (1) de quartz et le tronçon extrême du tube (7) d'introduction de gaz est courbé de façon que les trous (4, 5) d'introduction de gaz soient face à face.

3. Dispositif selon la revendication 1 ou 2, caractérisé en ce que lesdits trous d'introduction de gaz s'ouvrent dans une zone du tube (1) de quartz entourée par les moyens (2, 3) destinés à chauffer ledit tube de quartz.
